Europäisches Patentamt

European Patent Office

Office européen des brevets

(11) Veröffentlichungsnummer: **0 052 738**
A1

(12) # EUROPÄISCHE PATENTANMELDUNG

(21) Anmeldenummer: 81108175.1

(22) Anmeldetag: 10.10.81

(51) Int. Cl.³: **H 05 K 3/46**

(30) Priorität: 25.11.80 CH 8687/80

(43) Veröffentlichungstag der Anmeldung:
02.06.82 Patentblatt 82/22

(84) Benannte Vertragsstaaten:
CH DE FR GB IT LI NL SE

(71) Anmelder: CONTRAVES AG
Schaffhauserstrasse 580
CH-8052 Zürich(CH)

(72) Erfinder: Herzog, Max
Ettenfeldstrasse 3
CH-8052 Zürich(CH)

(72) Erfinder: Schmid, Franz
Grossacker 3
CH-8442 Hettlingen(CH)

(54) Leiterplatte.

(57) Leiterplatte (1) mit mindestens einer inneren Leitungsmusterschicht (4 bis 7), mit Leiterbahnen (2,3) auf mindestens einer Aussenfläche (41,42) sowie mit durch die Leiterplatte hindurchführenden Verbindungselementen (30,30').
Zur Verteilung des Speisestroms ist mindestens eine
Schicht aus Kupferblech (8,9) vorgesehen, die im wesentlichen parallel zur Leitungsmusterschicht (4 bis 7) verläuft.
Die Umrisse und Bohrungen der Kupferschicht werden
durch Formätzen erzeugt.

FIG. 1

EP 0 052 738 A1

Croydon Printing Company Ltd.

## Leiterplatte

Die Erfindung betrifft eine Leiterplatte gemäss dem Oberbegriff des Hauptanspruchs. Durch die Deutsche Offenlegungsschrift 26 27 297 ist eine mehrseitige, gedruckte Leiterplatte bekannt, die zur Verteilung der elektrischen Stromversorgung ein beidseitig kupferbeschichtetes Laminat als mittleren Kern aufweist. Diese Kupferschichten sind extrem dünnschichtig (max. 0,07 mm) und deshalb für hohe Stromstärken zu hochohmig.

Diese Schwäche kann zwar auf bekannte Weise dadurch behoben werden, dass zusätzlich eine oder mehrere Kupferschienen über den Backplane gelegt und mit den entsprechenden Steckeranschlüssen durch Handlöten verbunden werden. Die Erfahrung hat aber gezeigt, dass es nicht immer gelingt, beim Löten die Beanspruchung der Leiterplatte so zu steuern, dass die Backplanes bei Raumtemperatur plan bleiben. Restspannungen sind ausserdem unvermeidbar und führen zu Lötstellenrissen. Im Betriebstemperaturbereich von -40 bis 70$^{o}$C und insbesondere bei häufigen Temperaturwechseln treten solche Lötstellenrisse noch vermehrt in Erscheinung und sind so die Ursache von Ausfällen.

Es ist Aufgabe der Erfindung, eine Leiterplatte zu entwickeln, die sowohl eine niederohmige Stromversorgung und eine hohe Zuverlässigkeit bei häufigem Temperaturwechsel gewährleistet, als auch kostengünstig hergestellt werden kann.

Die Aufgabe wird dadurch gelöst, dass in der eingangs erwähnten Leiterplatte die Einrichtung zur Verteilung des Speisestroms aus mindestens einer im wesentlichen parallel zur Leitungsmusterschicht verlaufenden Schicht aus Kupferblech besteht.

Die Erfindung bietet den Vorteil, dass zusätzlich zur Funktion der Stromversorgung ohne wesentlichen weiteren Aufwand eine gute Wärmeverteilung und Wärmeabfuhr erreicht wird und damit die schädlichen mechanischen Beanspruchungen vermieden werden. Weitere Vorteile ergeben sich aus den Unteransprüchen.

Im folgenden soll die Erfindung anhand der Zeichnung erläutert werden.

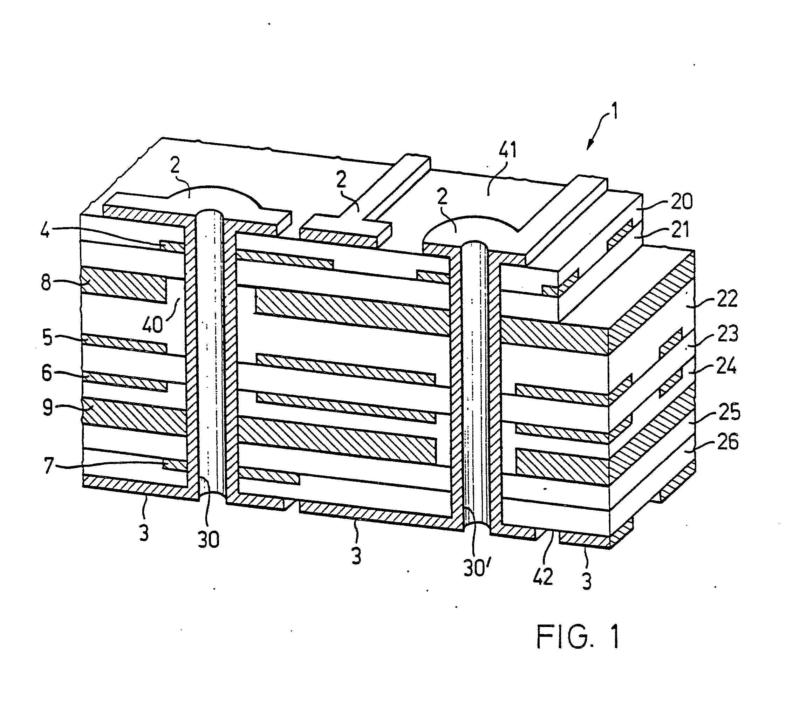

Die Figur 1 zeigt eine perspektivische Ansicht einer erfindungsgemässen Leiterplatte 1, bestehend aus den auf den beiden Aussenseiten 41, 42 angebrachten Leiterbahnen 2 und 3, den inneren Leitungsmusterschichten 4 bis 7, den beiden Stromversorgungsschichten 8 und 9 sowie mehreren elektrisch isolierenden Schichten 20 bis 26.

Die Leiterbahnen 2,3 auf den Aussenseiten wie auch die Leitungsmusterschichten 4 bis 7 sind in ihrer Auslegung entsprechend den Schaltungsbedingungen strukturiert. Sowohl die Anzahl der Leitungsmusterschichten als auch ihre Struktur ist nicht erfindungswesentlich.

Die Stromversorgungsschichten 8,9 bestehen aus Kupferblechen, die auf bekannte Weise mit den isolierenden Schichten 20 bis 26 verpresst werden. Als isolierende Schichten 20 bis 26 können beispielsweise die dem Fachmann gut bekannten Prepregs verwendet werden. Es hat sich als besonders vorteilhaft erwiesen, wenn für die Stromversorgungsschichten formgeätztes Kupferblech verwendet wird.
Die Stromversorgungsschichten 8,9 sind durch Zwischenschichtverbindungen 30,30' mit den Leitungsmusterschichten 4 bis 7 und den Leiterbahnen 2,3 auf den Aussenseiten

41,42 elektrisch verbunden. Die Zwischenschichtverbindungen 30,30' bestehen aus einem elektrisch leitenden Material, beispielsweise Kupfer, und sind entsprechend den Schaltungsbedingungen mit den Leitungsmusterschichten 4 bis 7 und den Stromversorgungsschichten 8,9 verbunden oder durch eine isolierende Zone getrennt. So ist in der Figur 1 die Stromversorgungsschicht 8 von der Zwischenschichtverbindung 30 durch die isolierende Zone 40 isoliert, die Stromversorgungsschicht 9 dagegen mit der Zwischenschichtverbindung 30 elektrisch in Kontakt.

Für die Stromversorgungsschichten werden insbesondere Bleche aus Walzkupfer oder Elektrolytkupfer verwendet. Eine bevorzugte Dicke der Stromversorgungsschichten 8,9 ist 0,2 mm, die aber entsprechend den Speisestromstärken und der Grösse der Leiterplatte auch im Bereich von 0,5 mm sein kann.

Patentansprüche

1. Leiterplatte (1) mit mindestens einer inneren Leitungsmusterschicht (4 bis 7), mit Leiterbahnen (2,3) auf mindestens einer Aussenfläche (41,42), mit durch die Leiterplatte hindurchführenden elektrischen Verbindungselementen (30,30'), sowie mit einer Einrichtung (8,9) zur Verteilung des Speisestroms auf die leitenden Schichten, dadurch gekennzeichnet, dass die Einrichtung zur Verteilung des Speisestroms aus mindestens einer im wesentlichen parallel zur Leitungsmusterschicht verlaufenden Schicht aus Kupferblech besteht.

2. Leiterplatte nach Anspruch 1, dadurch gekennzeichnet, dass das Kupferblech formgeätzt ist.

3. Leiterplatte nach Anspruch 1, dadurch gekennzeichnet, dass die Dicke des Kupferblechs zwischen 0,2 und 0,5 mm beträgt.

1|1

FIG. 1

Europäisches Patentamt

**EUROPÄISCHER RECHERCHENBERICHT**

Nummer der Anmeldung

EP 81 10 8175

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| XY | US - A - 3 932 932 (D.S. GOODMAN)<br><br> * Spalte 1, Zeilen 50-64; Spalte 2, Zeile 60 - Spalte 4, Zeile 45; Spalte 5, Zeilen 18-22; Figur 4 * | 1,3 |
| Y | US - A - 4 030 190 (K.J. VARKER)<br><br> * Spalte 2, Zeile 63 - Spalte 3, Zeile 46; Abbildungen * | 1 |
| Y | DE - A - 1 936 899 (SIEMENS A.G.)<br><br> * Seite 5, Absatz 5 - Seite 5, Absatz 4; Seite 8, Absatz 2; Figuren 1-4 * | 1 . |
| A | US - A - 3 958 317 (L.L. PEART et al.) | |

**KLASSIFIKATION DER ANMELDUNG (Int Cl ³)**

H 05 K 3/46

**RECHERCHIERTE SACHGEBIETE (Int. Cl.³)**

H 05 K 3/46

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsatze
E älteres Patentdokument. das jedoch erst am oder nach dem Anmeldedatum veroffentlicht worden ist
D: in der Anmeldung angeführtes Dokument
L: aus andern Grunden angeführtes Dokument

&: Mitglied der gleichen Patentfamilie. übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 02-03-1982 | SCHUERMANS |

EPA form 1503.1  06.78